# EUROPÄISCHE PATENTANMELDUNG

(11) **EP 2 868 625 A1**
(43) Veröffentlichungstag der Anmeldung: **06.05.2015**
(21) Anmeldenummer: 14189209.1
(22) Anmeldetag: 16.10.2014
(51) Int. Cl.: B81B 7/00

(54) **Mikroelektromechanische Sensoranordnung mit Dämpfungsschicht und Verfahren zum Herstellen dieser mikroelektromechanischen Sensoranordnung**

(30) Priorität: 04.11.2013 DE 102013222307
(71) Anmelder: ROBERT BOSCH GMBH, 70442 Stuttgart (DE)
(72) Erfinder: Ante, Frederik, 70197 Stuttgart (DE)

(57) **Zusammenfassung**

Die Erfindung betrifft eine mikroelektromechanische Sensoranordnung (100) mit einem Substrat (102), einer Dämpfungsschicht (104) und zumindest einem mikroelektromechanischen Sensorelement (106). Das Substrat (102) weist eine Kontakteinrichtung (108) zum elektrischen Kontaktieren der Sensoranordnung (100) auf. Die Dämpfungsschicht (104) ist auf einer Oberseite des Substrats (102) angeordnet. Die Dämpfungsschicht (104) ist dazu ausgebildet, mechanische Schwingungen zu dämpfen. Das Sensorelement (106) ist mit der Dämpfungsschicht (104) mechanisch verbunden. Das Sensorelement (106) ist mit der Kontakteinrichtung (108) des Substrats (102) über, die Dämpfungsschicht (104) überbrückende, schwingungsfeste elektrische Leiter (110) verbunden.

## Beschreibung

### Stand der Technik

Die vorliegende Erfindung bezieht sich auf eine mikroelektromechanische Sensoranordnung sowie auf ein Verfahren zum Herstellen einer mikroelektromechanischen Sensoranordnung.

Elektromechanische Sensoren können durch Schwingungen gestört werden, die beispielsweise eine zu erfassende Größe überlagern können.

Die DE 10 2006 026 878 A1 beschreibt ein Premold-Gehäuse mit integrierter Schwingungsisolierung.

### Offenbarung der Erfindung

Vor diesem Hintergrund wird mit der vorliegenden Erfindung mikroelektromechanische Sensoranordnung sowie ein Verfahren zum Herstellen einer mikroelektromechanischen Sensoranordnung gemäß den Hauptansprüchen vorgestellt. Vorteilhafte Ausgestaltungen ergeben sich aus den jeweiligen Unteransprüchen und der nachfolgenden Beschreibung.

Zum Entkoppeln eines elektromechanischen Sensorelements von störenden Schwingungen kann ein großer konstruktiver Aufwand betrieben werden, der auch in einer sehr guten Dämpfung der Schwingungen resultiert.

Auch durch eine konstruktiv einfache Lösung können gute Dämpfungseigenschaften erreicht werden, indem möglichst unmittelbar zwischen dem Sensorelement und einem tragenden Substrat ein dauerelastisches Dämpfungsmaterial angeordnet wird.

Durch diesen vereinfachten Aufbau können Fertigungskosten reduziert werden. Weiterhin kann der Aufbau mit fortschreitender Miniaturisierung ebenfalls miniaturisiert werden.

Es wird eine mikroelektromechanische Sensoranordnung mit folgenden Merkmalen vorgestellt:
einem Substrat mit einer Kontakteinrichtung zum elektrischen Kontaktieren der Sensoranordnung;
einer auf einer Oberseite des Substrats angeordneten Dämpfungsschicht zum Dämpfen von mechanischen Schwingungen; und
zumindest einem mit der Dämpfungsschicht mechanisch verbundenen mikroelektromechanischen Sensorelement, das mit der Kontakteinrichtung des Substrats über, die Dämpfungsschicht überbrückende, schwingungsfeste elektrische Leiter verbunden ist.

Unter einem Substrat kann ein Trägermaterial, beispielsweise eine Leiterplatte verstanden werden. Eine Kontakteinrichtung kann eine Schnittstelle zum elektrischen Verbinden der Sensoranordnung mit einer elektrischen Schaltung verstanden werden. Eine Dämpfungsschicht kann aus einem elastischen, schwingungsdämpfenden Material bestehen. Beispielsweise kann die Dämpfungsschicht aus einem Elastomer bestehen. Eine Oberseite des Substrats kann eine, bei bestimmungsgemäß verbauter Sensoranordnung, von einer Auflagefläche der Sensoranordnung abgewandte Seite, beispielsweise eine Außenfläche, des Substrats sein. Ein schwingungsfester Leiter kann beispielsweise ein Bonddraht sein.

Die Kontakteinrichtung kann eine Durchkontaktierung aufweisen, um die Oberseite mit einer, der Oberseite gegenüberliegenden Kontaktierungsseite des Substrats elektrisch zu verbinden. Eine Kontaktierungsseite kann die Auflagefläche der Sensoranordnung sein. Durch ein Kontaktieren der Sensoranordnung an der Kontaktierungsseite kann die Sensoranordnung in automatisierten Bestückungsprozessen einfach verarbeitet werden.

Das Substrat kann eine Vertiefung aufweisen, in der die Dämpfungsschicht angeordnet ist. Durch eine Vertiefung kann das Dämpfungsmaterial bei der Herstellung in flüssigem Zustand in die Vertiefung eingebracht werden, ohne seitlich wegfließen zu können. Nach dem Einbringen kann das Dämpfungsmaterial vernetzt werden, um seine Dämpfungseigenschaften zu erreichen.

Das Substrat kann zumindest aus zwei miteinander verbundenen Lagen bestehen, wobei die Vertiefung durch eine Aussparung in der, an der Oberseite angeordneten Lage ausgebildet ist. Die einzelnen Lagen können leicht und kostengünstig hergestellt werden.

Das Sensorelement kann zumindest teilweise von der Dämpfungsschicht umschlossen sein. Durch ein zumindest teilweises Umschließen des Sensorelements kann eine Kippstabilität des Sensorelements verbessert werden.

Das Sensorelement kann eine Trägerplatte aufweisen, die mechanisch mit der Dämpfungsschicht verbunden ist. Eine Trägerplatte kann Raum für zusätzliche Sensorelemente bieten. Die Trägerplatte kann eine Kontaktfläche des Sensorelements zu der Dämpfungsschicht vergrößern.

Die Sensoranordnung kann zumindest ein weiteres Sensorelement und/oder einen elektrischen Schaltkreis aufweisen, das mit der Kontakteinrichtung elektrisch verbunden ist. Ein weiteres Sensorelement kann zumindest eine weitere Erfassungsrichtung zur Verfügung stellen. Dadurch kann die Sensoranordnung vielseitiger verwendet werden.

Das weitere Sensorelement und/oder der weitere elektrische Schaltkreis kann mechanisch mit einer, auf der Oberseite des Substrats angeordneten weiteren Dämpfungsschicht verbunden sein. Das weitere Sensorelement kann mit der Kontakteinrichtung des Substrats über weitere, die weitere Dämpfungsschicht überbrückende, schwingungsfeste elektrische Leiter verbunden sein. Die weitere Dämpfungsschicht kann insbesondere andere Dämpfungseigenschaften aufweisen, als die Dämpfungsschicht. Durch mehrere individuell ausgelegte Dämpfungsschichten, die sich in ihren Abmessungen und/oder in ihren mechanischen Eigenschaften unterscheiden können, kann jedes Sensorelement individuell abgestimmt werden, sodass jedes Sensorelement bedarfsgerecht von den Schwingungen entkoppelt ist.

Das weitere Sensorelement und/oder der weitere elektrische Schaltkreis kann auch direkt auf der Oberseite des Substrats angeordnet sein.

Die Sensoranordnung kann zumindest einen integrierten Schaltkreis aufweisen, der mit dem Sensorelement und der Kontakteinrichtung elektrisch über schwingungsfeste Leiter verbunden ist. Durch einen integrierten Schaltkreis kann ein Signal des Sensorelements direkt in der Sensoranordnung verarbeitet werden.

Der integrierte Schaltkreis kann zusammen mit dem Sensorelement mechanisch mit der Dämpfungsschicht verbunden sein. Der Schaltkreis kann als Tilgungsmasse zum Erhöhen einer trägen Masse des Sensorelements verwendet werden. Die träge Masse kann auch durch Zusatzgewichte am Sensorelement erhöht werden.

Ein weiterer elektrischer Schaltkreis kann direkt mit dem Sensorelement verbunden sein.

Das weitere Sensorelement und der weitere elektrische Schaltkreis können mechanisch mit der weiteren Dämpfungsschicht verbunden sein.

Das Substrat kann im Bereich des Sensorelements einen Durchbruch aufweisen. Im Bereich des Durchbruchs kann die Dämpfungsschicht ebenfalls einen Durchbruch aufweisen, durch den das Sensorelement temporär mechanisch fixierbar ist.

Die vorliegende Erfindung schafft ferner ein Verfahren zum Herstellen einer mikroelektromechanischen Sensoranordnung, wobei das Verfahren die folgenden Schritte aufweist:
Bereitstellen eines Substrats mit einer Kontakteinrichtung, einer Dämpfungsschicht und eines Sensorelements;
Aufbringen der Dämpfungsschicht auf eine Oberseite des Substrats;
Verbinden des Sensorelements mit der Dämpfungsschicht; und
Kontaktieren des Sensorelements mit der Kontakteinrichtung unter Verwendung flexibler elektrischer Leiter.

Die Dämpfungsschicht kann als Platte bereitgestellt werden. Dann kann die Dämpfungsschicht unter Verwendung eines Klebstoffs auf das Substrat aufgeklebt werden. Die Dämpfungsschicht kann auch als zumindest eine Flüssigkeit oder Gel bereitgestellt werden, die nach dem Aufbringen zu einer formstabilen Schicht vernetzt. Beispielsweise können zumindest zwei Komponenten zu einem Polymer polymerisieren. Ebenso kann das Polymerisieren durch Hitze und/oder elektromagnetische Wellen und/oder Licht ausgelöst und/oder beschleunigt werden. Zum Verbinden des Sensorelements mit der Dämpfungsschicht kann ein Klebstoff verwendet werden. Ebenso kann das Dämpfungsmaterial Klebeeigenschaften aufweisen und die Verbindung des Sensorelements mit der Dämpfungsschicht herstellen. Das Sensorelement kann mit der Kontakteinrichtung durch Bonden verbunden werden. Dazu können beispielsweise Bonddrähte oder Bändchen zwischen Kontaktflächen des Sensorelements und Kontaktflächen der Kontakteinrichtung angeordnet werden. Das Bonden kann unter Verwendung von Ultraschall erfolgen.

Die Erfindung wird nachstehend anhand der beigefügten Zeichnungen beispielhaft näher erläutert. Es zeigen:
- Fig. 1: ein Blockschaltbild einer mikroelektromechanischen Sensoranordnung gemäß einem Ausführungsbeispiel der vorliegenden Erfindung;
- Fig. 2: eine Darstellung einer mikroelektromechanischen Sensoranordnung gemäß einem Ausführungsbeispiel der vorliegenden Erfindung;
- Fig. 3: eine Draufsicht auf eine mikroelektromechanische Sensoranordnung gemäß einem Ausführungsbeispiel der vorliegenden Erfindung;
- Fig. 4: eine Darstellung einer Sensoranordnung mit einer Vertiefung im Substrat gemäß einem Ausführungsbeispiel der vorliegenden Erfindung;
- Fig. 5: eine Darstellung einer Sensoranordnung mit teilweise von der Dämpfungsschicht umschlossenem Sensorelement gemäß einem Ausführungsbeispiel der vorliegenden Erfindung;
- Fig. 6a: eine Darstellung einer Sensoranordnung mit zwei Dämpfungsschichten gemäß einem Ausführungsbeispiel der vorliegenden Erfindung;
- Fig. 6b: eine Darstellung einer Sensoranordnung mit zwei Dämpfungsschichten und zwei integrierten Schaltkreisen gemäß einem Ausführungsbeispiel der vorliegenden Erfindung;
- Fig. 7: eine Draufsicht auf eine Sensoranordnung mit zwei Dämpfungsschichten gemäß einem Ausführungsbeispiel der vorliegenden Erfindung;
- Fig. 8a: eine Darstellung einer Sensoranordnung mit einem direkt auf dem Substrat befestigten zweiten Sensorelement gemäß einem Ausführungsbeispiel der vorliegenden Erfindung;
- Fig. 8b: eine Darstellung einer Sensoranordnung mit einem direkt auf dem Substrat befestigten zweiten Sensorelement und zwei integrierten Schaltkreisen gemäß einem Ausführungsbeispiel der vorliegenden Erfindung;
- Fig. 9: eine Draufsicht auf eine Sensoranordnung mit einem direkt auf dem Substrat befestigten zweiten Sensorelement gemäß einem Ausführungsbeispiel der vorliegenden Erfindung;
- Fig. 10: eine Darstellung einer Sensoranordnung mit einem Durchbruch durch das Substrat gemäß einem Ausführungsbeispiel der vorliegenden Erfindung;
- Fig. 11: eine Draufsicht auf eine Sensoranordnung mit einem Durchbruch durch das Substrat gemäß einem Ausführungsbeispiel der vorliegenden Erfindung;
- Fig. 12: eine Darstellung einer Sensoranordnung mit Sensorelementen in Flip-Chip Ausführung gemäß einem Ausführungsbeispiel der vorliegenden Erfindung;
- Fig. 13: eine Darstellung einer Sensoranordnung mit teilweise von der Dämpfungsschicht umschlossenem Sensorelement gemäß einem weiteren Ausführungsbeispiel der vorliegenden Erfindung; und
- Fig. 14: ein Ablaufdiagramm eines Verfahrens zum Herstellen einer mikroelektromechanischen Sensoranordnung gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

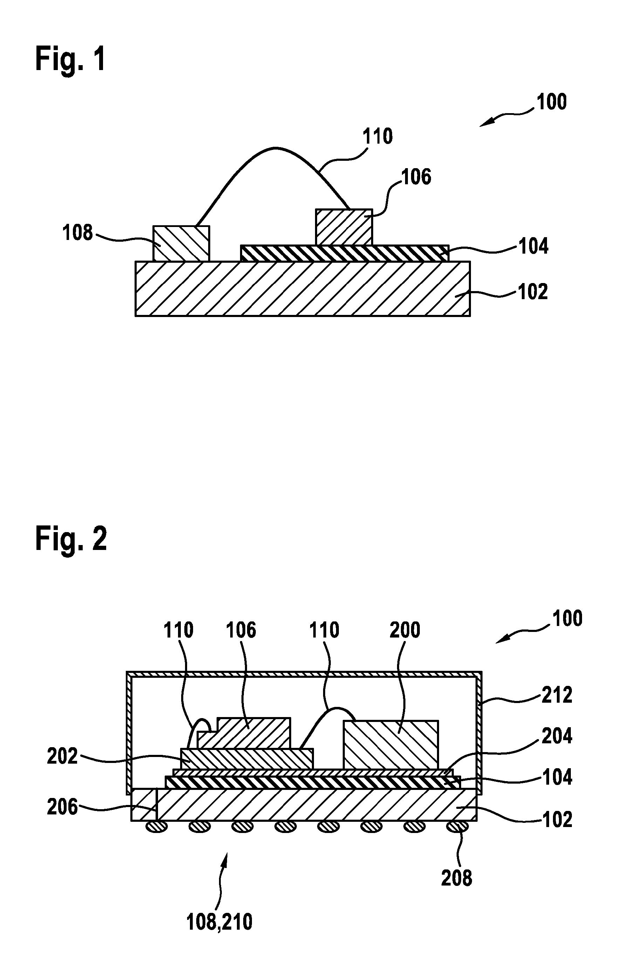

Fig. 1 zeigt ein Blockschaltbild einer mikroelektromechanischen Sensoranordnung 100 gemäß einem Ausführungsbeispiel der vorliegenden Erfindung. Die Sensoranordnung 100 weist ein Substrat 102, eine Dämpfungsschicht 104 und ein mikroelektromechanisches Sensorelement 106 auf. Das Substrat 102 weist eine Kontakteinrichtung 108 zum elektrischen Kontaktieren der Sensoranordnung 100 auf. Die Dämpfungsschicht 104 ist dazu ausgebildet, mechanische Schwingungen zu dämpfen. Die Dämpfungsschicht 104 ist auf einer Oberseite des Substrats angeordnet. Das Sensorelement 106 ist mit der Dämpfungsschicht 104 mechanisch verbunden. Das Sensorelement 106 ist mit der Kontakteinrichtung 108 des Substrats 102 über, die Dämpfungsschicht 104 überbrückende, flexible elektrische Leiter 110 elektrisch verbunden.

In einem Ausführungsbeispiel ist das Sensorelement 106 unmittelbar mit der Dämpfungsschicht 104 verbunden.

In Einem Ausführungsbeispiel ist das Sensorelement 106 auf einer Kontaktplatte befestigt, die mit der Dämpfungsschicht 104 mechanisch verbunden ist.

Fig. 2 zeigt eine Darstellung einer mikroelektromechanischen Sensoranordnung 100 gemäß einem Ausführungsbeispiel der vorliegenden Erfindung. Die Sensoranordnung 100 entspricht im Wesentlichen der Sensoranordnung in Fig. 1. Zusätzlich weist die Sensoranordnung 100 ein zweites Sensorelement 200 und einen integrierten Schaltkreis 202 bzw. ASIC 202 auf. Der integrierte Schaltkreis 202 bzw. IC 202 und das zweite Sensorelement 200 sind nebeneinander auf einer Trägerplatte 204 befestigt. Die Trägerplatte 204 ist mechanisch mit der Dämpfungsschicht 104 verbunden. Das erste Sensorelement 106 in Form, ist auf dem integrierten Schaltkreis 202 befestigt. Die Sensorelemente 106, 200 sind durch Leiter 110 mit dem IC 202 elektrisch verbunden. Der IC 202 ist durch die Leiter 110 bzw. Drahtbonds 110 mit der Kontakteinrichtung 108 verbunden. Die Kontakteinrichtung 108 weist Durchkontakte 206 bzw. elektrische Vias 206 auf und verbindet die Oberseite mit einer, der Oberseite gegenüberliegenden Kontaktierungsseite des Substrats 102 elektrisch. Auf der Kontaktierungsseite weist die Kontakteinrichtung 108 eine Mehrzahl von Kontaktflächen auf, die in einem Raster angeordnet sind. Auf jeder Kontaktfläche ist eine Lotkugel 208 angeordnet. Die Kontaktflächen und Lotkugeln bzw. Löt-Balls 208 bilden ein Ball-Grid-Array 210 aus. Alternativ kann auch auf die Balls 208 verzichtet werden, so dass das System als Land-Grid-Array ausgeführt wird. Die Sensorelemente 106, 200 und der IC 202 sind durch einen Deckel 212 abgedeckt und geschützt.

Mit anderen Worten zeigt Fig. 2 ein LGA/BGA Substrat 100 zur mechanischen Dämpfung von Mikrosystemtechnik-Sensoren, sogenannten MEMS-Sensoren 106, 200 (MEMS =micro-electro-mechanical systems).

Der hier vorgestellte Ansatz ermöglicht insbesondere bei modernen LGA/BGA-Gehäusen eine wirksame Entkopplung von Leiterplatte 102 und Sensor 106, 200, obwohl das Gehäuse 100 über keine Leads verfügt, welche bei etwa SOIC Gehäusen für eine gewisse Vibrationsentkopplung sorgen.

Der hier vorgestellte Ansatz beschreibt eine kostengünstige, kleinbauende 1st-Level Aufbautechnik und Verbindungstechnik zum Entkoppeln von Vibrationen in allen drei Raumrichtungen. Durch den hier vorgestellten Ansatz kann eine verringerte Störanfälligkeit der MEMS-Sensoren 106, 200 am Einbauort erreicht werden. Die schwingungsentkoppelnde Struktur 104 hier im 1st-Level und somit direkt in der Leiterplatte 102 des eigentlichen LGA/BGA-Gehäuses 100 integriert.

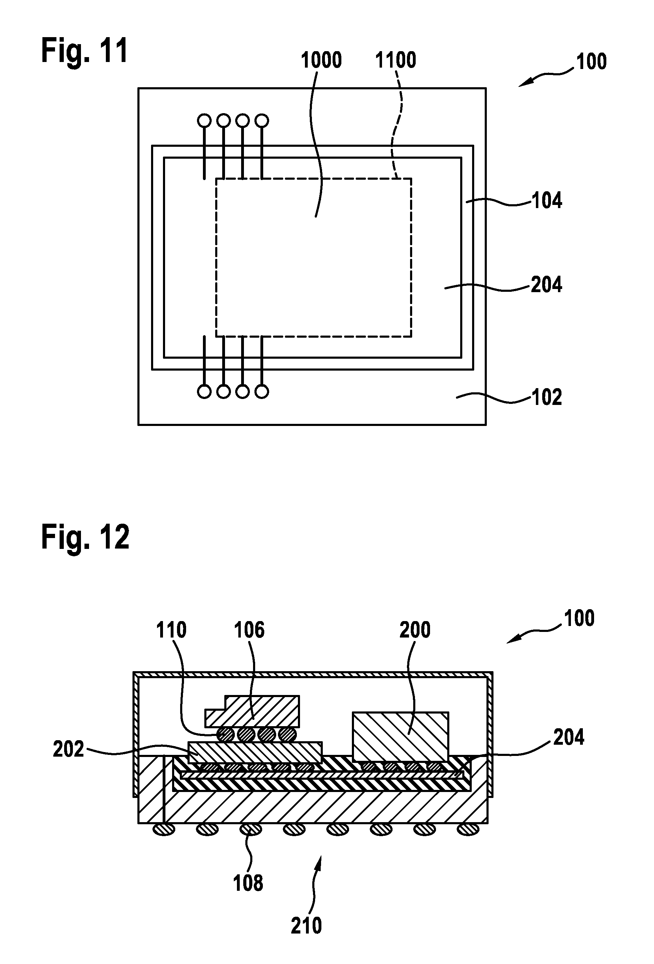

Bei dem hier vorgestellten Ansatz ist auf einem Substrat 102, beispielsweise einer Leiterplatte 102, ein Dämpfungsmaterial 104 integriert, auf dem sich MEMS-Sensoren 106, 200 und ASIC(s) 202 befinden. Das Dämpfungsmaterial 104 sorgt für eine mechanische Entkopplung zwischen den MEMS-Sensoren 106, 200 und dem Substrat 102, welches beispielsweise durch Löten starr an ein weiteres nicht dargestelltes Substrat, wie eine weitere, größere Leiterplatte gefügt wird. Das Substrat 102 enthält auf beiden Seiten Metallisierungen 108 in Form von Leiterbahnen, welche durch elektrische Vias 206 durch dieses Substrat 102 miteinander verbunden sind. Die Metallisierungen 108 auf der Oberfläche können durch Bonden oder auch teilweise Löten mit den MEMS-Sensoren 106, 200 und ASIC(s) 202 verbunden werden. Die Metallflächen 210 auf der Unterseite können durch Löten oder Leitkleber mit dem weiteren Substrat starr gefügt werden. Die MEMS-Sensoren 106, 200 können sich auf einer Trägerplatte 204 befinden. Dadurch kann das Bonden der Sensoren 106, 200 durch einen harten Untergrund erleichtert werden. Ebenso kann der Drehpunkt der MEMS-Sensoren 106, 200 auf der Leiterplatte 102 analog zum Auswuchten angepasst werden. Das Trägersubstrat 204 bzw. die Trägerplatte 204 kann elektrische Leitungen beinhalten, sodass die Sensoren 106, 200 auch im Flip-Chip-Verfahren aufgebracht werden können, wie beispielsweise in Fig. 12 dargestellt.

Die hier beschriebene Sensoranordnung 100 kann ohne Layoutänderung als BGA 210 (Ball-Grid-Array, mit Lötballs 208) oder als LGA-Version (Land-Grid-Array) hergestellt werden. Für die Fertigung des Substrates 102 müssen keine kritischen Toleranzen für Fräsen oder Lasern eingehalten werden. Dadurch lässt sich die Erfindung sehr leicht miniaturisieren.

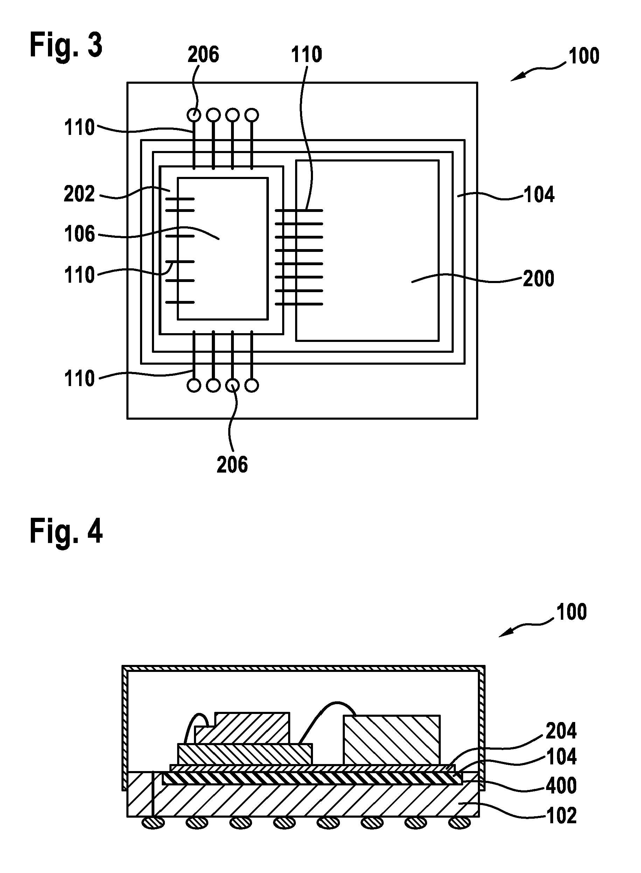

Fig. 3 zeigt eine Draufsicht auf eine mikroelektromechanische Sensoranordnung 100 gemäß einem Ausführungsbeispiel der vorliegenden Erfindung. Die Sensoranordnung 100 entspricht der Sensoranordnung in Fig. 2. Die Sensoren 106, 200 sind mit einer Mehrzahl von nebeneinander in einer Richtung ausgerichteten Leitern 110 mit dem IC 202 verbunden. Die Leiter 110 mit denen das erste Sensorelement 106 und das zweite Sensorelement 200 mit dem IC 202 verbunden sind, sind quer zu den Leitern 110 ausgerichtet, mit denen der IC 202 mit der Kontakteinrichtung 108 verbunden ist. Dadurch kann eine versehentliche Berührung der Leiter 110 verhindert werden. Die Kontakteinrichtung 108 weist hier eine Mehrzahl von Durchkontaktierungen 206 auf. Der IC 202 ist auf einer Seite mit mehreren Durchkontaktierungen 206 und auf einer gegenüberliegenden Seite ebenso mit mehreren mit Durchkontaktierungen 206 verbunden. Die Anzahl der Durchkontakte und elektrischen Verbindungen ist entsprechend des verwendeten Bauteils 202 variabel.

In den Figuren 2 und 3 ist die Dämpfungsschicht 104 als tragfähige Lage auf eine Oberfläche des Substrats 102 aufgebracht worden.

In einem Ausführungsbeispiel ist die Dämpfungsschicht 104 unter Verwendung einer Klebeschicht auf das Substrat 102 aufgeklebt worden.

In einem Ausführungsbeispiel ist die Dämpfungsschicht 104 in pastöser Form auf dem Substrat 102 angeordnet worden, beispielsweise durch Aufspritzen oder Schablonendruck, und durch einen Vernetzungsprozess zu einer tragfähigen Schicht umgewandelt worden.

Dargestellt ist ein Schnitt und Aufsicht des Dämpfersystems 100 mit Dämpfungsmaterial 104 auf dem Substrat 102. Die MEMS-Sensoren 106, 200 sind mit dem ASIC 202 durch Drahtbonds 110 elektrisch verbunden. Der ASIC 202 ist über Drahtbonds 110 mit der Substratoberfläche elektrisch verbunden. Auf dem Substrat 102 werden die Signale über Leiterbahnen 108 und elektrische Vias 206 auf die Unterseite umgeleitet. In dieser Version ist das Substrat 102 als BGA 210 ausgeführt. Ebenso kann das Substrat 102 als LGA ausgeführt sein.

Über die Dicke des Dämpfungsmaterials 104 und/oder der Trägerplatte 204 und/oder zumindest ein zusätzliches Gewicht ist die Lage der Resonanzfrequenz des Dämpfers 100 einstellbar. Das System aus Dämpfungsmaterial 104 und Trägerplatte 204/Sensoren 106, 200 ist durch einen Deckel 212 gehaust. Dieser Deckel 212 kann aus Kunststoff oder aus Metall bestehen.

Fig. 4 zeigt eine Darstellung einer Sensoranordnung 100 mit einer Vertiefung 400 im Substrat 102 gemäß einem Ausführungsbeispiel der vorliegenden Erfindung. Die Sensoranordnung 100 entspricht im Wesentlichen der Sensoranordnung in Fig. 2. Im Gegensatz dazu bildet die Vertiefung 400 eine Art Wanne aus, in der die Dämpfungsschicht 104 angeordnet ist. Eine Auflagefläche der Trägerplatte 204 auf der Dämpfungsschicht 104 ist hier bündig mit der Oberfläche des Substrats 102. Durch die Vertiefung 400 kann auch Dämpfungsmaterial in flüssigem Zustand oder dickflüssigem Zustand verwendet werden, um die Dämpfungsschicht 104 auszubilden, da das Dämpfungsmaterial durch die Vertiefung 400 vor dem Vernetzen bzw. während des Herstellungsprozesses nicht seitlich wegfließen kann.

In einem Ausführungsbeispiel besteht das Substrat 102 zumindest aus zwei miteinander verbundenen Lagen. Die Vertiefung 400 ist durch eine Aussparung in der, an der Oberseite angeordneten Lage ausgebildet. Die Lagen werden separat vorbereitet und anschließend miteinander verklebt.

In einem Ausführungsbeispiel weist das Substrat 102 eine Kavität 400 auf, sodass auch ein (zunächst) nicht formfestes Dämpfungsmaterial 104 verwendet werden kann.

Durch den hier vorgestellten Ansatz wird eine kompakte Struktur 100 zur Entkopplung von mechanischen Schwingungen geschaffen, bei der sich ein hohes Potenzial zur Kostenersparnis ergibt. Wenn das Substrat 102 eine Kavität 400 beinhaltet, so kann diese ohne aufwendige Tiefenfräsung erstellt werden. Das Substrat 102 mit Kavität 400 kann aus zwei Teilsubstraten zusammengepresst werden, wovon das Erste keine Aussparungen, das Zweite eine Aussparung beinhaltet. Mehrere gleichartige Substrate 102 mit zumindest einer Aussparung können durch sogenanntes Stack-Fräsen kostengünstig gefertigt werden.

Wenn das Dämpfungsmaterial 104 formstabil ist, kann es beispielsweise per Siebdruck beim Leiterplattenprozess (Substrat=Leiterplatte) auf dem gesamten Nutzen aufgebracht werden. Das Verspritzen der Einzelsysteme wäre in diesem Fall nicht nötig.

Nicht-formstabile Materialien können beim Leiterplattenprozess oder anschließend in die Kavität 400 gespritzt oder dispensiert werden.

In hier dargestellten Ausführungsformen befindet sich das Dämpfungsmaterial 104 nicht auf der Leiterplatte 102, sodass es nicht formstabil sein muss (formstabil beim Aufbringen oder bestehend aus einer Gelmatte). Für nicht formstabile Dämpfungsmaterialien kann eine Kavität 400 durch Zusammenpressen mehrerer Lagen im Substrat 102 hergestellt werden. In diese Kavität 400 kann das Dämpfungsmaterial 104 eingebracht werden und wird seitlich begrenzt.

Mit anderen Worten zeigt Fig. 4 einen Schnitt durch Sensoren 106, 200 auf Dämpfungsmaterial 104, wobei das Dämpfungsmaterial 104 in dem Substrat 102 angeordnet ist.

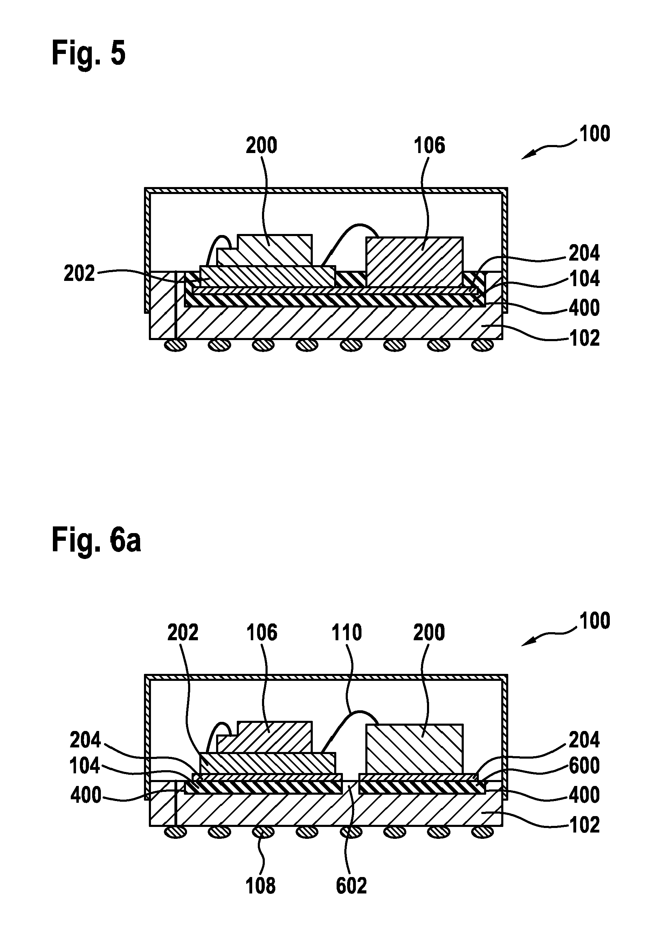

Fig. 5 zeigt eine Darstellung einer Sensoranordnung 100 mit teilweise von der Dämpfungsschicht 104 umschlossenem Sensorelement 106 gemäß einem Ausführungsbeispiel der vorliegenden Erfindung. Die Sensoranordnung 100 entspricht im Wesentlichen der Sensoranordnung in Fig. 4. Im Gegensatz dazu sind das erste Sensorelement 106 und das zweite Sensorelement 200 vertauscht. Hier ist das erste Sensorelement direkt auf der Trägerplatte 204 befestigt, während das zweite Sensorelement 200 auf dem IC 202 befestigt ist. Zusätzlich ist die Vertiefung 400 hier wesentlich tiefer in das Substrat 102 eingebracht, als in Fig. 4. Die Trägerplatte 204 mit dem ersten Sensorelement 106, dem zweiten Sensorelement 200 und dem IC 202 ist während des Herstellungsprozesses in das flüssige oder pastöse Dämpfungsmaterial eingedrückt worden, sodass das Dämpfungsmaterial die Trägerplatte 204 vollständig umschließt. Dabei umschließt das Dämpfungsmaterial auch das erste Sensorelement 106 und den IC 202 teilweise. Nachdem die Trägerplatte 204 in Position gebracht wurde, ist das Dämpfungsmaterial vernetzt worden, um die Dämpfungsschicht 104 auszubilden. Jetzt ist die Trägerplatte 204 mit den Sensorelementen 106, 200 und dem IC 202 von der Dämpfungsschicht 104 umschlossen.

Die Trägerplatte 204 kann auch in das Dämpfungsmaterial 104 eingetaucht werden. Hierdurch wird der Drehpunkt des Systems "Trägerplatte 204 mit MEMS-Sensoren 106, 200" erniedrigt und störende Drehbeschleunigungen durch den Dämpfer 104 selbst werden reduziert. Dadurch kann das System ausgewuchtet werden. Das Dämpfungsmaterial 104 kann in Form einer Gelmatte einfach auf das Substrat 104 aufgeklebt werden.

In einem Ausführungsbeispiel besteht die Sensoranordnung 100 aus einem Substrat 102, z. B. einer Leiterplatte 102 mit einem Dämpfungsmaterial 104 auf der Oberseite. Das Dämpfungsmaterial 104 besteht beispielsweise aus einem weichen Kunststoff oder Silikon. Die MEMS-Sensoren 106, 200, der ASIC 202 befinden sich auf einer Trägerplatte 204, beispielsweise aus Metall oder Kunststoff, welche auf das Dämpfungsmaterial 104 gefügt ist.

In einem nicht dargestellten Ausführungsbeispiel ist zumindest einer der Sensoren 106, 200 direkt auf das Dämpfungsmaterial 104 gesetzt. In diesem Fall ist die Trägerplatte 204 überflüssig. Die direkte Verbindung von MEMS 106, 200 und Dämpfungsmaterial 104 kann durch intrinsische Klebeeigenschaften des Dämpfungsmaterials 104 oder durch einen geeigneten Klebstoff hergestellt werden.

In einer Ausführungsform befindet sich der Schwerpunkt des Systems Trägerplatte 204/Sensoren 106, 200 über dem Drehpunkt der Sensoranordnung 100. Der Drehpunkt liegt in etwa mittig auf der Oberfläche des Dämpfungsmaterials 104. Diese Situation (Drehpunkt über Schwerpunkt) kann unter Umständen zu einem Störsignal führen, weil eine linear anregende Beschleunigung durch das Dämpfungsmaterial 104 in eine Drehbeschleunigung (=Verkippung der Sensoren) umgewandelt wird. Um diese Störung zu vermeiden, kann das Dämpfersystem 100 ausgewuchtet werden. Das Auswuchten ist bei dem vorgestellten Ansatz durch Anpassen der Masse der Trägerplatte 204 (Dicke, Material, Zusatzgewicht) und/oder ein Eindrücken des Systems Trägerplatte 204/Sensoren 106, 200 in das Dämpfungsmaterial 104 möglich. Dieses Eindrücken ist möglich, wenn das Dämpfungsmaterial 104 nach der Prozessierung noch weich ist (z. B. Gel vor Vernetzung durch thermisches Ausheizen). Das Eindrücken kann in verschiedenen Ausprägungen erfolgen. Beispielsweise kann das System Trägerplatte 204/Sensoren 106, 200 nur teilweise, d. h. noch auf dem Dämpfungsmaterial 104 aufliegend oder komplett, d. h. kein Dämpfungsmaterial 104 unter der Trägerplatte 204, gefertigt werden. Dabei können auch nur Teile der Trägerplatte 204 in das Dämpfungsmaterial 104 gedrückt werden und die MEMS-Sensoren 106, 200/ASICs 202 noch vollständig aus diesem herausragen. Diese Ausführungsform ist hier nicht dargestellt.

Mit anderen Worten zeigt Fig. 5 einen Schnitt durch Sensoren 106, 200 in dem Dämpfungsmaterial 104 schwebend.

Fig. 6a zeigt eine Darstellung einer Sensoranordnung 100 mit zwei Dämpfungsschichten 104, 600 gemäß einem Ausführungsbeispiel der vorliegenden Erfindung. Die Sensoranordnung 100 entspricht im Wesentlichen der Sensoranordnung in Fig. 4. Im Gegensatz dazu sind das erste Sensorelement 106 mit dem IC 202 und das zweite Sensorelement 200 auf je einer eigenen Trägerplatte 204 angeordnet. Ferner ist eine zweite Dämpfungsschicht 600 zwischen dem zweiten Sensorelement 200 und dem Substrat 102 angeordnet. Dabei ist das zweite Sensorelement 200 mit der Kontakteinrichtung 108 des Substrats 102 über weitere, die weitere Dämpfungsschicht überbrückende, flexible elektrische Leiter 110 verbunden. Die Trägerplatten 204 und die Dämpfungsschichten 104, 600 sind nebeneinander in eigenen Vertiefungen 400 angeordnet und durch einen Steg 602 des Substrats 102 räumlich voneinander getrennt.

In einem Ausführungsbeispiel weist die erste Dämpfungsschicht 104 andere Dämpfungseigenschaften auf, als die zweite Dämpfungsschicht 600.

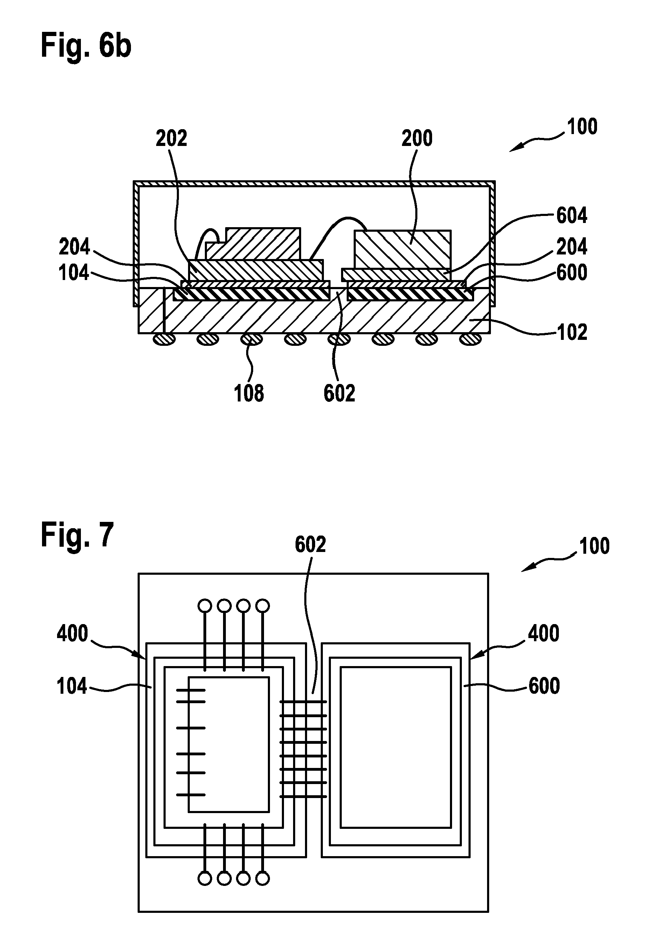

Mit anderen Worten zeigt Fig. 6 einen Schnitt durch zwei verschiedene Dämpfersysteme.

Fig. 6b zeigt eine Darstellung einer Sensoranordnung 100 mit zwei Dämpfungsschichten 104, 600 und zwei integrierten Schaltkreisen (IC) 202, 604 gemäß einem Ausführungsbeispiel der vorliegenden Erfindung. Die

Sensoranordnung 100 entspricht im Wesentlichen der Sensoranordnung in Fig. 6a. Zusätzlich ist zwischen dem zweiten Sensorelement 200 und der zweiten Trägerplatte 204 der zweite IC 604 angeordnet. Der zweite IC 604 ist elektrisch mit dem zweiten Sensorelement 200 sowie mit der Kontakteinrichtung 108 verbunden. Der zweite IC 604 ist gemeinsam mit dem zweiten Sensor 200 durch die zweite Dämpfungsschicht schwingungsentkoppelt.

Fig. 7 zeigt eine Draufsicht auf eine Sensoranordnung 100 mit zwei Dämpfungsschichten 104, 600 gemäß einem Ausführungsbeispiel der vorliegenden Erfindung. Die Sensoranordnung 100 entspricht im Wesentlichen der Sensoranordnung in Fig. 6a. Hier ist deutlich der Steg 602 zwischen den zwei Vertiefungen 400 zu erkennen, durch den die Dämpfungsmaterialien der beiden Dämpfungsschichten 104, 600 bei der Herstellung voneinander getrennt sind.

Dargestellt ist eine Ausführungsform, in der zwei verschiedene Dämpfungsmaterialien 104, 600 für den ersten Sensor 106 und den zweiten Sensor 200 verwendet werden. Die Prozessierung dieses Substrats 102 ist möglich, indem ein Rest-Steg 602 in der Kavität 400 zwischen erstem Sensor 106 und zweitem Sensor 200 stehen bleibt, sodass für beide Sensoren 106, 200 unterschiedliche Dämpfungsmaterialien 104, 600 verwendet werden können.

Bei der lokalen Dämpfung der Sensoren 106, 200 können getrennte Kavitäten 400 für dem ersten Sensor 106 und den zweiten Sensor200 verwendet werden, sodass verschiedene Dämpfungsmaterialien 104, 600 verwendet werden können.

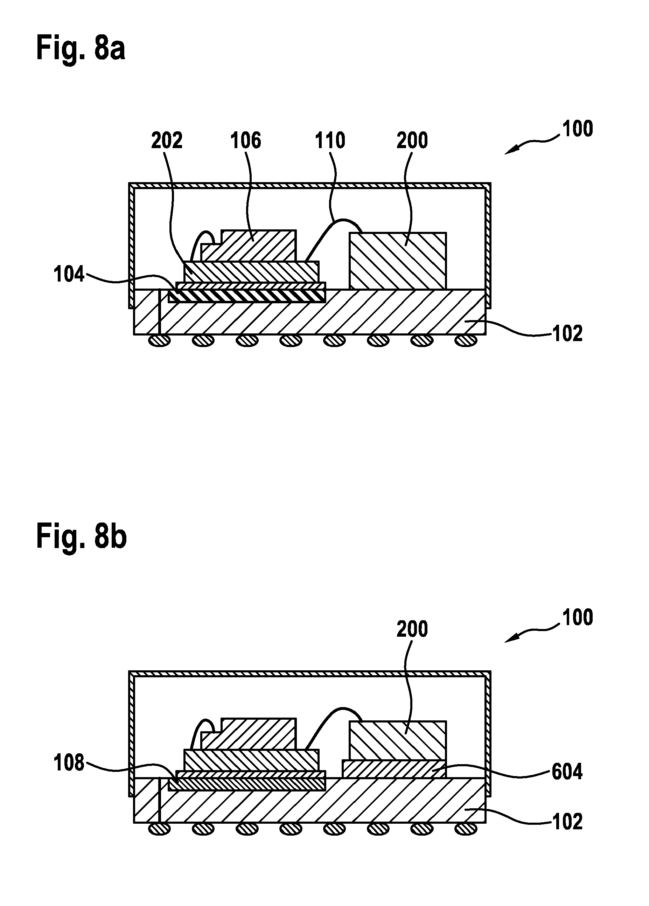

Fig. 8a zeigt eine Darstellung einer Sensoranordnung 100 mit einem direkt auf dem Substrat 102 befestigten zweiten Sensorelement 200 gemäß einem Ausführungsbeispiel der vorliegenden Erfindung. Im Wesentlichen entspricht die Sensoranordnung 100 der Sensoranordnung in Fig. 6a. Im Gegensatz dazu sind hier die zweite Vertiefung, die zweite Dämpfungsschicht und die zweite Trägerplatte entfallen. Das zweite Sensorelement 200 ist unmittelbar auf der Oberseite des Substrats 102 angeordnet und zumindest mechanisch mit dem Substrat verbunden. Das erste Sensorelement 106 sowie der IC 202 sind wie in Fig. 6a auf ihrer Dämpfungsschicht 104 befestigt. Hier ist das zweite

Sensorelement 200 über flexible elektrische Leiter 110 mit dem IC 202 verbunden, da der IC 202 gegenüber dem zweiten Sensorelement 200 hier relativbeweglich ist.

Fig. 8b zeigt eine Darstellung einer Sensoranordnung 100 mit einem direkt auf dem Substrat 102 befestigten zweiten Sensorelement 200 und zwei integrierten Schaltkreisen 202, 604 gemäß einem Ausführungsbeispiel der vorliegenden Erfindung. Im Wesentlichen entspricht die Sensoranordnung 100 der Sensoranordnung in Fig. 8a. Zusätzlich ist zwischen dem zweiten Sensorelement 200 und dem Substrat 102 der zweite IC 604 angeordnet. Der zweite IC 604 ist elektrisch mit dem zweiten Sensorelement 200 sowie mit der Kontakteinrichtung 108 verbunden. Der weitere elektrische Schaltkreis 604 ist direkt auf dem Substrat 102 befestigt.

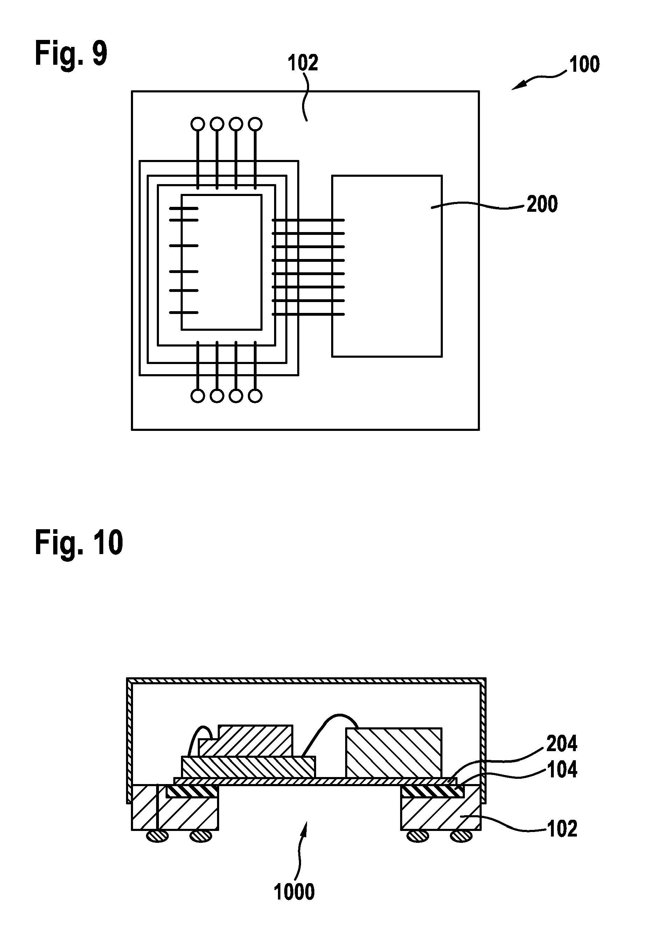

Fig. 9 zeigt eine Draufsicht auf eine Sensoranordnung 100 mit direkt auf dem Substrat 102 befestigten zweiten Sensorelement 200 gemäß einem Ausführungsbeispiel der vorliegenden Erfindung. Die Sensoranordnung 100 entspricht der Sensoranordnung in Fig. 8a.

Fig. 10 zeigt eine Darstellung einer Sensoranordnung 100 mit einem Durchbruch 1000 durch das Substrat 102 gemäß einem Ausführungsbeispiel der vorliegenden Erfindung. Die Sensoranordnung 100 entspricht im Wesentlichen der Sensoranordnung in Fig. 4. Im Gegensatz dazu ist ein zentraler Bereich des Substrats 102 und der Dämpfungsschicht 104 unterhalb der Trägerplatte 204 durchbrochen. Damit liegt in diesem Bereich die Trägerplatte 204 mit ihrer Auflageseite auf der Dämpfungsschicht 104 frei und ist, in der Darstellung von unten, zugänglich. Durch den Durchbruch 1000 ist die Trägerplatte 204 während des Herstellungsprozesses temporär fixierbar und exakt platzierbar.

In allen Ausführungsformen dient ein Substrat 102 (z. B. Leiterplatte 102) als Grundbaustein des Dämpfer-Systems 100. Auf diesem Substrat 102 befindet sich ein dämpfendes Elastomer 104, auf welchem sich die Trägerplatte 204 mit den MEMS 106, 200/ASIC 202 befindet. Beim Drahtbonden wird mittels Ultraschall der Bonddraht 110 mit dem Pad auf dem MEMS 106, 200/ASIC 202 verschmolzen.

Mit anderen Worten zeigt Fig. 10 einen Schnitt durch die Sensoren 106, 200 auf dem Dämpfungsmaterial 104, das in das Substrat 102 eingelassen ist. Das Substrat 102 weist eine Aussparung 1000 auf, um beim Drahtbonden mit einem Werkzeug einen Gegendruck aufzubauen.

Fig. 11 zeigt eine Draufsicht auf eine Sensoranordnung 100 mit einem Durchbruch 1000 durch das Substrat 102 gemäß einem Ausführungsbeispiel der vorliegenden Erfindung. Die Sensoranordnung 100 entspricht der Sensoranordnung in Fig. 10. In der gezeigten Darstellung sind das erste und das zweite Sensorelement sowie der IC ausgeblendet. Dadurch ist der Blick auf die Trägerplatte 204 frei. Der Durchbruch 1000 ist durch die Trägerplatte 204 verdeckt. Der Durchbruch 1000 ist durch die Darstellung einer verdeckten Kante 1100 repräsentiert. Der Durchbruch 1000 befindet sich zentral unter der Trägerplatte 204. An einem ringförmig geschlossen umlaufenden Rand liegt die Trägerplatte 204 auf der Dämpfungsschicht 104 auf. Der Durchbruch 1000 ist kleiner, als die Trägerplatte 204.

Fig. 12 zeigt eine Darstellung einer Sensoranordnung 100 mit Sensorelementen 106, 200 in Flip-Chip Ausführung gemäß einem Ausführungsbeispiel der vorliegenden Erfindung. Die Sensoranordnung 100 entspricht im Wesentlichen der Sensoranordnung in Fig. 5. Im Gegensatz dazu sind die Sensorelemente 106, 200 und der IC 202 über direkte Lötverbindungen analog des Ball-Grid-Arrays 210 der Sensoranordnung 100 miteinander verbunden. Dazu weist die Trägerplatte 204 Leiterbahnen auf, die das erste Sensorelement 106 mit dem IC 202 verbinden. Über die Leiterbahnen können Sensorsignale von dem ersten Sensorelement 106 zu dem IC 202 geleitet werden. Der IC 202 und/oder die Trägerplatte 204 sind weiterhin über flexible Leiter 110 mit der Kontakteinrichtung 108 verbunden.

Generell können die MEMS 106, 200/ASICs 202 anders als durch Drahtbonds 110 mit dem Substrat 102 elektrisch verbunden werden. Es ist auch eine Flip-Chip-Montage nur auf der Trägerplatte 204 oder teilweise auf der Trägerplatte 204 und auf der Leiterplatte 102 bei einer lokalen Dämpfung des ersten Sensors 106 möglich. Bei der Flip-Chip-Montage enthält die Trägerplatte 204 elektrische Strukturen zur Umverdrahtung. Mit Drahtbonds 110 werden in diesem Fall die Trägerplatte 204 und das Substrat 102 oder andere Sensoren/ASICs elektrisch verbunden. In der Fig. 12 ist die Flip-Chip-Montage der MEMS 106, 200 auf der Trägerplatte gezeigt. In diesem Fall ist die Trägerplatte 110 mit Drahtbonds 110 elektrisch mit dem Substrat 102 oder anderen Sensoren verbunden.

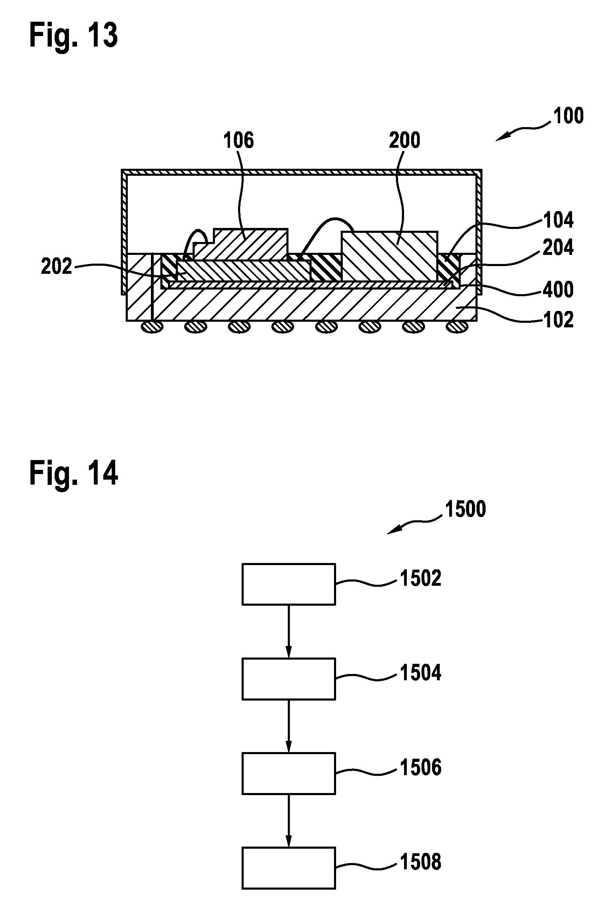

Fig. 13 zeigt eine Darstellung einer Sensoranordnung 100 mit teilweise von der Dämpfungsschicht 104 umschlossenem Sensorelement 106 gemäß einem weiteren Ausführungsbeispiel der vorliegenden Erfindung. Die Sensoranordnung 100 entspricht im Wesentlichen der Sensoranordnung in Fig. 5. Im Gegensatz zu Fig. 5 ist die Trägerplatte mit den Sensorelementen 106, 200 und dem IC 202 innerhalb der Vertiefung 400 bis auf das Substrat 102 abgesenkt. Damit sind die Sensorelemente 106, 200 nur noch gegen seitliche Vibrationen gedämpft, jedoch ist die Montage der Sensorelemente (Bestücken, Kontaktieren) im Herstellungsprozess vereinfacht.

Fig. 14 zeigt ein Ablaufdiagramm eines Verfahrens 1500 zum Herstellen einer mikroelektromechanischen Sensoranordnung gemäß einem Ausführungsbeispiel der vorliegenden Erfindung. Das Verfahren 1500 weist einen Schritt 1502 des Bereitstellens, einen Schritt 1504 des Aufbringens, einen Schritt 1506 des Verbindens und einen Schritt 1508 des Kontaktierens auf. Im Schritt 1502 des Bereitstellens werden ein Substrat mit einer Kontakteinrichtung, eine Dämpfungsschicht und ein Sensorelement bereitgestellt. Im Schritt 1504 des Aufbringens wird die Dämpfungsschicht auf eine Oberseite des Substrats aufgebracht. Im Schritt 1506 des Verbindens wird das Sensorelement mit der Dämpfungsschicht verbunden. Im Schritt 1508 des Kontaktierens wird das Sensorelement mit der Kontakteinrichtung unter Verwendung flexibler elektrischer Leiter kontaktiert.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Mikroelektromechanische Sensoranordnung (100) mit folgenden Merkmalen:
einem Substrat (102) mit einer Kontakteinrichtung (108) zum elektrischen Kontaktieren der Sensoranordnung (100);
einer auf einer Oberseite des Substrats (102) angeordneten Dämpfungsschicht (104) zum Dämpfen von mechanischen Schwingungen; und
zumindest einem mit der Dämpfungsschicht (104) mechanisch verbundenen mikroelektromechanischen Sensorelement (106), das mit der Kontakteinrichtung (108) des Substrats (102) über, die Dämpfungsschicht (104) überbrückende, schwingungsfeste elektrische Leiter (110) verbunden ist.

2. Sensoranordnung (100) gemäß Anspruch 1, bei der die Kontakteinrichtung (108) eine Durchkontaktierung aufweist, um die Oberseite mit einer, der Oberseite gegenüberliegenden Kontaktierungsseite des Substrats (102) elektrisch zu verbinden.

3. Sensoranordnung (100) gemäß einem der vorangegangenen Ansprüche, bei der das Substrat (102) eine Vertiefung (400) aufweist, in der die Dämpfungsschicht (104) angeordnet ist.

4. Sensoranordnung (100) gemäß Anspruch 3, bei der das Substrat (102) zumindest aus zwei miteinander verbundenen Lagen besteht und die Vertiefung (400) durch eine Aussparung in der, an der Oberseite angeordneten Lage ausgebildet ist.

5. Sensoranordnung (100) gemäß einem der vorangegangenen Ansprüche, bei der das Sensorelement (106) zumindest teilweise von der Dämpfungsschicht (104) umschlossen ist.

6. Sensoranordnung (100) gemäß einem der vorangegangenen Ansprüche, bei der das Sensorelement (106) eine Trägerplatte (204) aufweist, die mechanisch mit der Dämpfungsschicht (104) verbunden ist.

7. Sensoranordnung (100) gemäß einem der vorangegangenen Ansprüche, mit zumindest einem weiteren Sensorelement (200) und/oder elektrischen Schaltkreis (200), das mit der Kontakteinrichtung (108) elektrisch verbunden ist.

8. Sensoranordnung (100) gemäß Anspruch 7, bei der das weitere Sensorelement (200) und/oder der weitere elektrische Schaltkreis (200) mechanisch mit einer, auf der Oberseite des Substrats (102) angeordneten weiteren Dämpfungsschicht (600) verbunden ist, wobei das weitere Sensorelement (200) mit der Kontakteinrichtung (108) des Substrats (102) über weitere, die weitere Dämpfungsschicht (600) überbrückende, schwingungsfeste elektrische Leiter (110) verbunden ist, wobei die weitere Dämpfungsschicht (600) insbesondere andere Dämpfungseigenschaften aufweist, als die Dämpfungsschicht (104).

9. Sensoranordnung (100) gemäß Anspruch 7, bei der das weitere Sensorelement (200) und/oder der weitere elektrische Schaltkreis (200) direkt auf der Oberseite des Substrats (102) angeordnet ist.

10. Sensoranordnung (100) gemäß einem der vorangegangenen Ansprüche, mit einem integrierten Schaltkreis (202), der mit dem Sensorelement (106) und der Kontakteinrichtung (108) elektrisch verbunden ist.

11. Sensoranordnung (100) gemäß Anspruch 10, bei der der integrierte Schaltkreis (202) zusammen mit dem Sensorelement (106) mechanisch mit der Dämpfungsschicht (104) verbunden ist.

12. Sensoranordnung (100) gemäß einem der Ansprüche 10bis 11, bei der ein weiterer elektrischer Schaltkreis direkt mit dem Sensorelement (200) verbunden ist.

13. Sensoranordnung (100) gemäß Anspruch 12, bei der das weitere Sensorelement (200) und der weitere elektrische Schaltkreis mechanisch mit der weiteren Dämpfungsschicht (600) verbunden sind.

14. Sensoranordnung (100) gemäß einem der vorangegangenen Ansprüche, bei der das Substrat (102) im Bereich des Sensorelements (106) einen Durchbruch (1000) aufweist, wobei im Bereich des Durchbruchs (1000) die Dämpfungsschicht (104) ebenfalls einen Durchbruch (1000) aufweist, durch den das Sensorelement (106) temporär mechanisch fixierbar ist.

15. Verfahren (1500) zum Herstellen einer mikroelektromechanischen Sensoranordnung (100), wobei das Verfahren (1500) die folgenden Schritte aufweist:
Bereitstellen (1502) eines Substrats (102) mit einer Kontakteinrichtung (108), einer Dämpfungsschicht (104) und eines Sensorelements (106);
Aufbringen (1504) der Dämpfungsschicht (104) auf eine Oberseite des Substrats (102);
Verbinden (1506) des Sensorelements (106) mit der Dämpfungsschicht (104); und
Kontaktieren (1508) des Sensorelements (106) mit der Kontakteinrichtung (108) unter Verwendung flexibler elektrischer Leiter (110).
